# EUROPEAN PATENT APPLICATION

(11) **EP 4 716 407 A1**
(43) Date of publication of application: **25.03.2026**
(21) Application number: 25179405.3
(22) Date of filing: 28.05.2025
(51) Int. Cl.: H10D 30/66, H10D 30/01, H10D 64/00, H10D 64/27, H10D 62/10, H10D 62/13, H10D 62/832

(54) **SILICON CARBIDE TRENCH MOSFET**

(30) Priority: 18.09.2024 US 202418888549
(71) Applicant: II-VI Delaware, Inc., Wilmington, DE 19890 (US)
(72) Inventor: KONSTANTINOV, Andrei, Wilmington, 19890 (US)
(74) Representative: Tegethoff, Sebastian

(57) **Abstract**

A new design of a silicon carbide (SiC) metal-oxide-semiconductor field-effect transistor (MOSFET) and method of manufacturing the MOSFET are disclosed. The SiC MOSFET features a trench formed in SiC layers that includes a buried p-well region near the bottom of the trench that extends along a sidewall of the trench. The SiC MOSFET may also include a p-body and built-in channel on an opposite sides of the trench. The SiC MOSFET configurations may help prevent dielectric breakdown and bipolar degradation in the SiC.

## Description

### Background

Silicon carbide (SiC) metal-oxide-semiconductor field-effect transistors (MOSFETs) are becoming a preferred power component for use in high-voltage power conversion. However, the relatively low inversion layer electron mobility in SiC can increase the necessary chip area for the power conversion, as well as the manufacturing cost, when compared to conventional devices. The increased chip area can further increase the gate, the drain, and the feedback capacitances that can adversely affect the switching loss. Also, the reliability of the gate oxide in a SiC MOSFET is significant. The gate oxide in a SiC MOSFET can experience a critical field that is ten times higher than that of traditional Si MOSFETs. Accordingly, some SiC MOSFETs configurations can be susceptible to dielectric breakdown. Further, bipolar degradation in SiC can occur from the growth of Shockley stacking faults as a result of basal-plane dislocation splitting into partials. If minority carrier recombination occurs in these devices, the SiC basal-plane dislocations split into Shockley partials leaving a stacking fault in between. The Shockley stacking faults act as a resistive barrier for vertical electron transport through the drift region, which can increase the drain-source on resistance (i.e., R_{ds}(on)) beyond the expected value and risk power system failure. Minority carrier injection in a conventional SiC MOSFET during turn-on of the body diode, during so-called thirdquadrant operation.

Yet another reliability aspect is related to the requirement for safe operation under the short-circuit conditions at the load. Silicon carbide MOSFETs are generally known to develop high short-circuit currents under such circumstances, which makes it practically difficult to build the driver topology with a sufficiently fast response time to prevent the part failure due to the thermal dissipation.

### Brief Summary of the Disclosure

In general, embodiments are directed to a new design of a SiC trench MOSFET. The SiC trench MOSFET features an n-type source at the top surface and a p-body layer immediately underneath said n-type source. An n-type current spreading layer is formed below the p-body layer. Said regions are formed at the top side of an epitaxial structure that includes a low-resistivity n-type substrate with a lightly doped n-type drift region on top of it. The low-resistivity substrate acts as drain of the trench MOSFET.

In a general aspect, a trench may be formed at the top side of SiC crystal which penetrates through a source region, a p-body layer, and a portion of the current spreading layer. The trench has first and second sidewalls and a trench bottom. A shielding p-well region may be arranged next to the second trench sidewall and to at least a portion of the trench bottom to form a continuous L-shaped region. The trench in SiC is formed by two layers of polysilicon, which are electrically insulated from each other by an interlayer dielectric (ILD). The first polysilicon layer is arranged as an L-shaped body, which body is adjacent to bottom and second sidewall of the trench in SiC crystal. The second polysilicon layer is arranged between the first polysilicon layer and the first sidewall of said trench in SiC and is insulated from said first sidewall by a layer of gate oxide, which gate oxide may be significantly thinner than the ILD. The first polysilicon layer may be heavily p-type doped and is shorted to the source region. The p-well region is also shorted to the source region. The interface of the first polysilicon layer is configured to form a Schottky barrier to n-type SiC with low resistivity in forward bias. The second polysilicon region represents the gate of the trench MOSFET, which gate may be configured to form an electron inversion channel at the interface of the p-body region and the gate oxide under positive gate bias. The Schottky barrier formed by the first polysilicon layer forms a built-in body diode with a low forward drop, which body diode may prevent minority carrier injection under so-called 3rd quadrant operation mode, for which the MOSFET drain is positively biased, while the MOSFET gate is in an off-state.

In another aspect, a shallow built-in n-type channel layer may be provided along the n-type SiC region that is adjacent to the trench in the SiC. The built-in channel layer forms a passively gated Junction Field Effect Transistor (JFET) with the polysilicon as the gate. Said passively gated JFET may be configured to have a low absolute value of a negative threshold voltage, which feature may be beneficial for decreasing open-state MOSFET current under the short-circuit conditions of the MOSFET load.

In another aspect, embodiments are directed towards a method of manufacturing a SiC MOSFET. The method includes ion implanting a current spreading layer on an epitaxial structure with a drift region layer disposed on a SiC wafer, and depositing a p-well layer onto the current spreading layer; depositing a source region onto the p-well layer; patterning a first mask to: ion implant to form a buried p-well region in the current spreading layer; deposit a sub-contact p-layer after the ion implantation; and removing the first mask; patterning a second mask to: etch a trench through the sub-contact p-layer, source layer, and p-well layer into the current spreading layer and in contact with the buried p-well region; and removing the second mask.

The method may also include inclined beam ion implanting to form a p-body on a portion of the bottom of the trench and the second sidewall using the second mask; and inclined donor ion implanting to form a built-in channel on a portion of the bottom of the trench and a portion of the first sidewall of the trench using the second mask.

This summary is intended to provide a brief overview of some of the subject matter described in this document. Accordingly, it will be appreciated that the above-described features are merely examples and should not be construed to narrow the scope or spirit of the subject matter described herein in any way. Other features, aspects, and advantages of the subject matter described herein will become apparent from the following Detailed Description, Figures, and Claims.

### Brief Description of the drawings

A better understanding of the present subject matter can be obtained when the following detailed description of various aspects is considered in conjunction with the following drawings.
Figure 1 illustrates a unit cell of an active region in accordance with one or more embodiments herein.
Figure 2 illustrates the topside portion of unit cell in accordance with one or more embodiments herein.
Figures 3A to 3K illustrate a process for manufacturing a trench-MOSFET in accordance with one or more embodiments herein.

While the features described herein may be susceptible to various modifications and alternative forms, specific aspects thereof are shown by way of example in the drawings and are herein described in detail. It should be understood, however, that the drawings and detailed description thereto are not intended to be limiting to the particular samples disclosed, but on the contrary, the intention is to cover all modifications, equivalents and alternatives falling within the spirit and scope of the subject matter as defined by the appended claims.

### Detailed Description of the Disclosure

Embodiments disclosed herein provide improved SiC trench MOSFETs with a buried field plate (BFP) formed by combination of a p-well region and, in some embodiments, a layer of a p-body. The BFP may help block current flow under off state conditions. The MOSFET further includes a polysilicon gate electrode arranged next to a gate dielectric, the gate dielectric being formed at the trench sidewall. As such, current from the source to the drain in an inversion channel may be formed at the vertical surface of the SiC p-body that forms the BFP using a positive bias at the MOSFET gate. During third quadrant operation when the forward current of the body diode flows through the Schottky rectifier formed by the contact of the polysilicon to n-type SiC, minority carrier injection may be prevented due to the lower forward drop of the Schottky diode compared to a p-n junction.

It is to be understood that the figures and descriptions of the present invention may have been simplified to illustrate elements that are relevant for a clear understanding of the present embodiments, while eliminating, for purposes of clarity, other elements found in MOSFET systems, or typical methods of manufacturing MOSFET devices. Those of ordinary skill in the art will recognize that other elements may be desirable and/or required in order to implement the present embodiments. However, because such elements are well known in the art, and because they do not facilitate a better understanding of the present embodiments, a discussion of such elements is not provided herein. It is also to be understood that the drawings included herewith only provide diagrammatic representations and that structures falling within the scope of the embodiments may include structures different than those shown in the drawings. Reference will now be made to the drawings where like structures are provided with like reference designations.

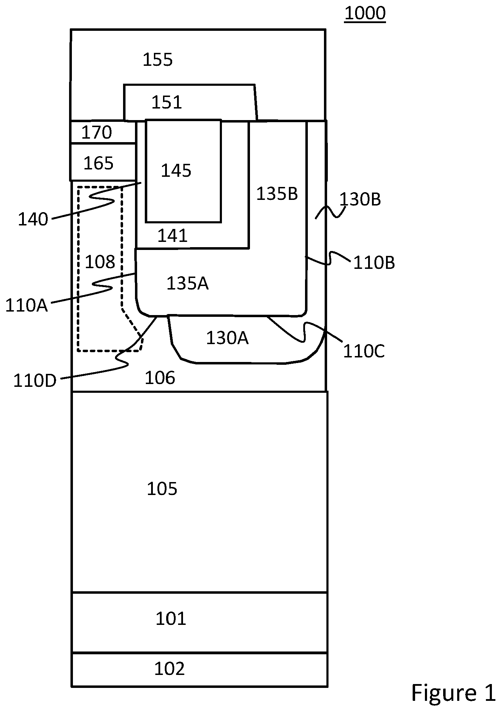

Figure 1 illustrates a trench-MOSFET structure in accordance with one or more embodiments herein. The MOSFET 1000 may be formed on hexagonal SiC, which structure was grown on a low-resistivity silicon carbide substrate 101. It is preferred, but not necessary, that the substrate polytype modification is 4H. 4H silicon carbide substrates are typically oriented close to the basal (0001) hexagonal crystal plane with an off-orientation angle of a few degrees. Such an off-orientation can achieve growth of high-quality epitaxial layer, so as to minimize inclusions of foreign polytype, such as cubic SiC.

The MOSFET 1000 includes a lightly doped drift region 105. The role of the drift region 105 is to withstand voltage without premature breakdown during the off-state conditions of MOSFET 1000, while conducting the drain current in on-state. Thickness and doping of the drift layer are determined by desired maximum blocking voltage with relevant numbers as disclosed by Konstantinov et al (Konstantinov et al in "Ionization rates and critical fields in 4H silicon carbide", Applied Physics Letters, vol. 71 No. 1, 1997, July, pp. 90-92). A usable power device should also include design margins in conjunction with said relevant numbers. As an example, a 1200-Volt rated power device in SiC would have a drift region of around 10 µm with a doping of around 1x10¹⁶ cm⁻³. A higher voltage rating requires a drift region of greater thickness and/or lower doping.

The topside portion of the n-type epitaxial layer will include a current-spreading layer 106 (CSL). The CSL 106 has a higher doping than the drift region 105 to provide sufficient conductance through a cross-section that is narrower than device pitch, which may be a few times the doping of the drift region 105. A highly doped n-type source region 170 is formed at the topside surface of the SiC crystal. A p-body layer 165 is formed underneath the source region 170. A trench 110A-D is formed in silicon carbide, which trench has opposite first and second sidewalls, 110A and 110B respectively, and a trench bottom 110C. A p-well region 130A, 130B is formed, and the p-well region 130A, 130B may include a sidewall portion at the p-well region 130B and a bottom portion at the p-well region 130A. The sidewall p-well region portion 130B of MOSFET 1000 extends from the trench bottom to the top surface of the SiC crystal. The p-well region 130A, 130B and the drift region 105 form the p-n junction that can block the high voltage under off-state MOSFET conditions. MOSFET 1000 further includes two layers of polysilicon, first polysilicon layer 135A-B and second polysilicon layer 145, which regions are insulated electrically from each other by a first ILD 141. The first ILD 141 may be at least partially formed by thermal oxidation of the first polysilicon layer 135. The first polysilicon layer 135 may be schematically split in Figure 1 into sidewall portion 135A and bottom portion 135B. The second polysilicon layer 145 represents the active MOS-gate, which gate may be electrically insulated from the second trench sidewall in SiC by a layer of gate oxide 140. The first ILD 141 may be significantly thicker than gate oxide 140, with a minimum thickness of around 200 nm, and, preferably, above 300 nm. This is required for achieving sufficiently reliable insulation of the first and second polysilicon layers, as well as for achieving an ILD contribution to the source-to-gate capacitance. The use of a thermally grown oxide in the interlayer dielectric may provide significant reliability benefit to MOSFET 1000 because the thermal oxides have a high critical field for electrical breakdown, greater than that of deposited oxides.

The second polysilicon layer 145 may be configured to form an inversion electron channel at the interface of the p-body layer 165 to the gate oxide 140 at the positive gate bias exceeding the gate threshold voltage. The electron current may then flow from the source region 170 though said inversion channel, through the vertical JFET 108 between p-well region 130B and elements 140/141/135/130A, through remaining portion of the CSL 106, and further down to the substrate 101 through the drift region 105. The vertical JFET 108 of MOSFET 1000 is schematically shown by a dashed line in Figure 1.

Certain design features of the MOSFET 1000 are addressed to achieve low on-state resistance without significant impact on blocking voltage and the gate reliability. The gate reliability in SiC may be affected by the high electric field, which may originate from the off-state drift region 105. Hot carriers might also be generated in drift region 105 at a high positive drain bias. The capturing of said hot carriers at the gate oxide may compromise the gate integrity. Physical separation of the blocking p-n junction formed by the p-well region 130A, 130B and CSL 106 from the gate oxide may be performed by a layer of the first polysilicon layer 135, which configuration increases the aspect ratio of the vertical JFET 108 as compared to other asymmetric MOSFETs (see, for example, U.S. Patent No. 10,553,685). The bottom first polysilicon layer 135 may be p-type to form a high barrier to the n-type SiC of the CSL. The high barrier may prevent excessive leakage currents in an off-state of MOSFET 1000. Such leakage may be inevitable for a low barrier, such as that of n-type polysilicon to n-type SiC. The trench corner 110D may be rounded to avoid undesired electric field crowding.

The left-hand edge of the p-well region 130A, 130B may be offset to the right from the trench corner 110D between 110A and 110C in order to minimize resistance of the open-state of MOSFET 1000. An attempt to align said two features laterally may result in excessive depletion of the lower portion of vertical JFET 108 because the built-in potential of a p-n junction barrier may be higher than that of a Schottky barrier. Lateral straggle of implanted acceptor ions in p-well region 130A, 130B may further decrease the width of non-depleted portion of vertical JFET 108.

The passive gate (first polysilicon layer 135) may be further configured to form a non-injecting Schottky-type body diode in MOSFET 1000. The requirement for body-diode conduction under negative drain bias of a n-channel power MOSFET is inevitable in multiple power-conversion circuit topologies. Minority carrier injection of a p-n type body diode may increase the switching losses due to minority-carrier extraction. Bipolar degradation due to splitting of basal-plane dislocations in SiC into Schockley partials under the conditions of minority carrier injection may be another issue with the p-n type body diode of SiC power MOSFETs. The built-in Schottky diode provided by the passive gate in the MOSFET 1000 alleviates said issues with the switching loss and reliability.

Configuring the passive-gate (first polysilicon layer 135) as a body-diode rectifier might require certain additional features of MOSFET design and process. Native oxide must be sufficiently removed from the surface of SiC prior to the deposition of the first polysilicon layer 135. The inventors have determined that a thin interfacial oxide layer between SiC and polysilicon may leave apparent barrier height identical to that of oxide-free interface. However, the on-state Schottky-diode resistance at high current densities may increase by a factor of over 10 for the polysilicon-dioxide-SiC barrier compared to the oxide-free interface. A Schottky-type body diode with excessive interfacial oxide might therefore appear useless to prevent high forward voltage drops and minority carrier injection. Having a (0001) SiC crystal at the interface to polysilicon as in MOSFET 1000 is beneficial to minimize the resistance of possible interfacial oxide, because this orientation of SiC has the lowest oxidation rate and the thinnest native oxide compared to other crystal planes of hexagonal SiC.

Portion 135B of the first polysilicon layer 135 provides means of shorting said first layer to the source with low series resistance. Portion 130B of the p-well region has also a similar function. Another function of the p-well region 130A, 130B is to provide electrostatic shielding of the passive Schottky gate 135.

Metallic drain contact 102 is attached to the bottom of the substrate 101, which contact is Ohmic. Another metallic contact, topside metal 155, is attached to the wafer top side, which contact is also ohmic. The metal 155 forms an ohmic contact to the source region 170 to the p-well region 130A, 130B and to the first polysilicon layer 135. A second ILD 151 provides electrical insulation of the topside metal 155 from the second polysilicon layer 145.

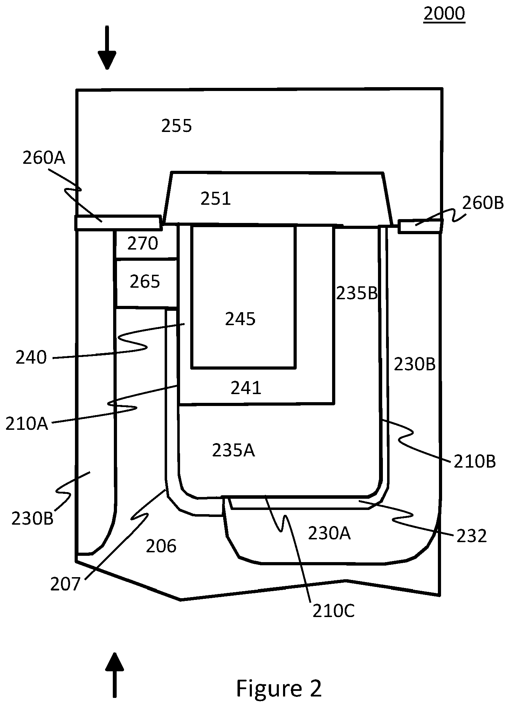

Figure 2 illustrates the topside portion trench-MOSFET structure 2000 in accordance with one or more embodiments herein. MOSFET 2000 may include a drift region, a low-resistivity substrate and a backside contact configured in the same manner as in MOSFET 1000 in Figure 1. We note that Figure 2 includes more than a single unit cell of the MOSFET 2000 according to the embodiment; it also includes a portion of a neighbor cell. The neighbor cell is located to the left from the cross-section along line AA1.

The topside portion of device 2000 has multiple similar features to those of MOSFET 1000. A trench with righthand sidewall 210B, a lefthand sidewall 210A and a trench bottom 210C is formed in silicon carbide. A shielding p-type body is formed from the p-well regions 230A, 230B and shielding p-body 232. Source region 270 and p-body layer 265 are formed next to the top SiC surface. Note that the p-well portion 260B belongs to the neighbor unit cell. The trench in SiC 210A-C is filled with two layers of polysilicon, 235 and 245, which are separated by first ILD 241 in the manner similar to that disclosed for MOSFET 1000. Second ILD 251 is formed to electrically insulate MOS-gate 245 from the topside metal 255. Note that configuration of 251 has a difference from that of 151: The second ILD 251 fully covers the first polysilicon 235B. Silicide-based ohmic contacts 260A and 260B may be formed over source 270. The gate 245 is arranged next to the second trench sidewall 210A, with a layer of gate oxide 240 between said gate 245 and sidewall 210A. The p-well region 230A, 230B and the first layer of polysilicon 235 of device 2000 are electrically shorted to the source region, same as in MOSFET 1000.

In device 2000, the grounding of the first polysilicon 235 is achieved through the contact of the first polysilicon layer 235 to the p-well region 230A, 230B. Such contact may be formed as a tunnel junction by providing a shallow heavily doped layer either for the horizontal portion 230A or to vertical portion 235B or to both regions 235A and 235B. In further embodiments electrical contact between the source metal and the first polysilicon can be achieved by their direct contact using a wider opening in the second ILD 251. The topside metal may be a stack of a diffusion barrier adjacent to the silicide and aluminum on top.

A shallow n-type built-in channel layer (BICL) 207 is arranged next to the trench edge in the current-spreading layer (CSL) 206, which BICL 207 consists of a vertical BICL portion and a horizontal portion. The vertical portion of BICL 207 may have a dose of implanted acceptors of between approximately 1x10¹² cm⁻² and 5x10¹² cm⁻² and a thickness between approximately 60 nm and a few hundred nm. The BICL 207 forms a Schottky barrier to the p-type polysilicon of the first layer of polysilicon, 235A. The BICL 207 may also extend vertically up to the p-body layer 265. The on-state electron current of device 2000 flows though from n-source 270, though the inversion channel formed at the sidewall of p-body layer 265 by the gate 245, though the vertical portion of BICL 207, through the CSL 206, and further down to the n+ substrate through the drift region. The thickness of the CSL portion between p-well region 230B and the vertical portion of BICL 207 may be chosen to ensure depletion of said portion under zero-bias conditions. The built-in JFET formed by the vertical portion of BICL 207 and the passive gate 235A can have a high aspect ratio, which is beneficial for suppression of short-channel effects and of drain-induced barrier lowering in the MOS-channel formed at the interface of p-body layer 265 and the gate oxide 240. The drain-to-drain feedback capacitance will be further reduced, with decreased switching losses as a result.

An additional benefit of device 2000 is the possibility to configure it for suppression of the drain current in a short-circuit (SC) event at the drain load. A high drain current is developed in SiC MOSFETs under SC load conditions, with the possibility of MOSFET destruction in a few microseconds unless the driver circuitry quickly detects the SC event and tuns off the positive gate bias. The suppression of the SC current is possible due to the long-channel JFET formed by the passive gate 235A and the vertical portion of BICL 207. If the absolute value of threshold voltage of said JFET (Vₜₕ) is below the gate voltage of MOSFET 2000 under standard on-state operation the current saturation in the JFET will decrease the peak current under the SC event. Said SC-current suppression will as well occur under the conditions of high drain bias because of the long-channel JFET configuration in device 2000.

The role of the horizontal portion of BICL 207 is to decrease the transition resistance between the vertical portion of the BICL 207 and the non-depleted portion of the CSL in region 206. The horizontal portion of the BICL 207 may have lower doping than the vertical portion of the BICL 207 and it may be formed thicker than the vertical portion of the BICL 207 to decrease its contribution to the source-to-drain capacitance. In some embodiments, the horizontal portion of the BICL 207B might be missing altogether, in which case the vertical doping profile of the CSL may have increased doping in the vicinity of SiC trench bottom, i.e., at the depth of the trench bottom 210C.

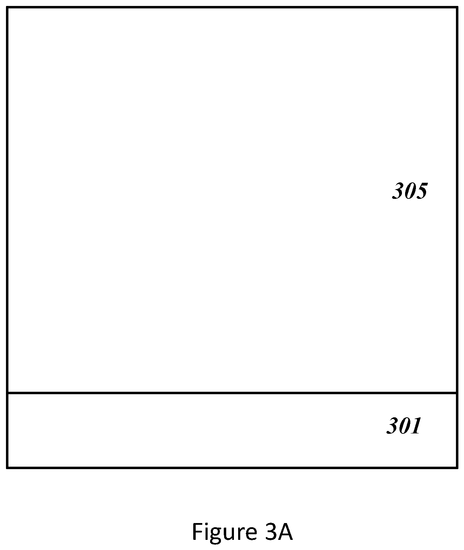

FIGS. 3A through 3K illustrate the manufacturing process of trench MOSFET 3000 according to one or more embodiments herein.

An example method of making disclosed example MOSFETs starts with an epitaxial structure, which consists of an epitaxial drift-region layer 305 formed on a low-resistivity substrate 301, as it is shown in Figure 3A. The substrate 301 may be the 4H polytype modification of SiC. Such substrates are typically oriented in the basal (0001) crystal plane with an off-orientation of a few degrees. The transition between substrate 301 and drift region 305 may further include one or more buffer layers, which layers are omitted in Figure 3A.

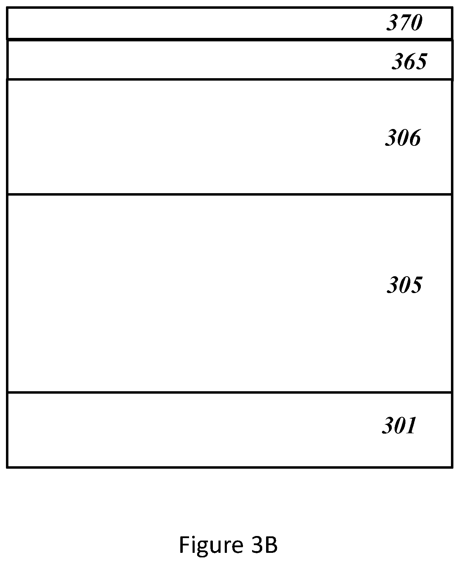

At the next stage (Figure 3B) source layer 370, p-body layer 365 and current-spreading layer 306 are formed at top side of the active region, for example by ion implantation into the drift region 105.

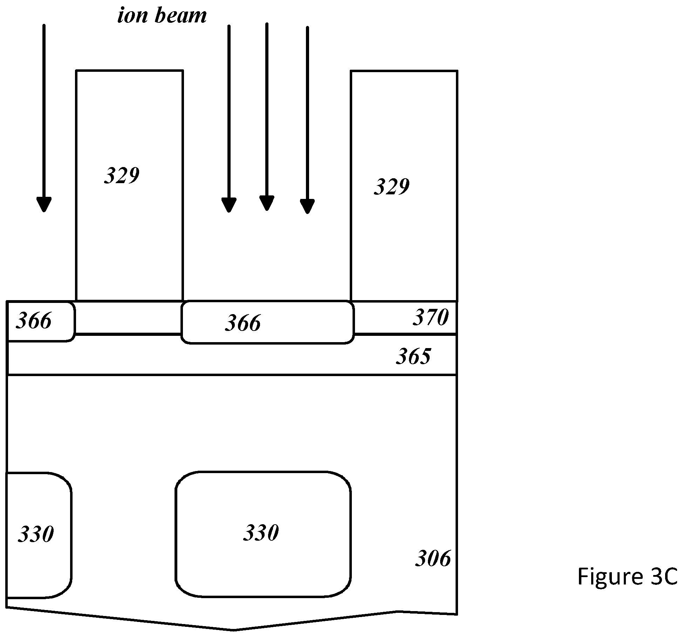

At the next stage (Figure 3C) a mask 329 is patterned. The mask may be silicon dioxide or a stack of silicon dioxide with photoresist on top. Acceptor ions are implanted to form a buried p-well region 330. Photoresist is then removed, if used. Sub-contact p-layer 366 is then implanted. The sub-contact p-layer 366 should have sufficient dose to overcompensate the n-source 370. The p-well region 330 may optionally extend all the way to the topside SiC surface. The p-well region depth may exceed 1 micron. The mask 329 is removed after the implants. Figure 3C also shows portions of the p-well region 330 and p-body layer 365 belonging to the left-hand neighbor unit cell. The entire power MOSFET is arranged as one or more linear arrays of said unit cells.

Channeled Al ion implants may be optionally used to achieve sufficiently deep ion penetration for the formation of p-well region 330 without using excessively high Al ion energies, as well as avoiding use of excessively thick mask 329. Said channel implant may be done prior to the formation of heavily doped shallow region 366, which region may otherwise produce strong ion de-channeling due to the ion damage in an attempt of implanting region 366 first.

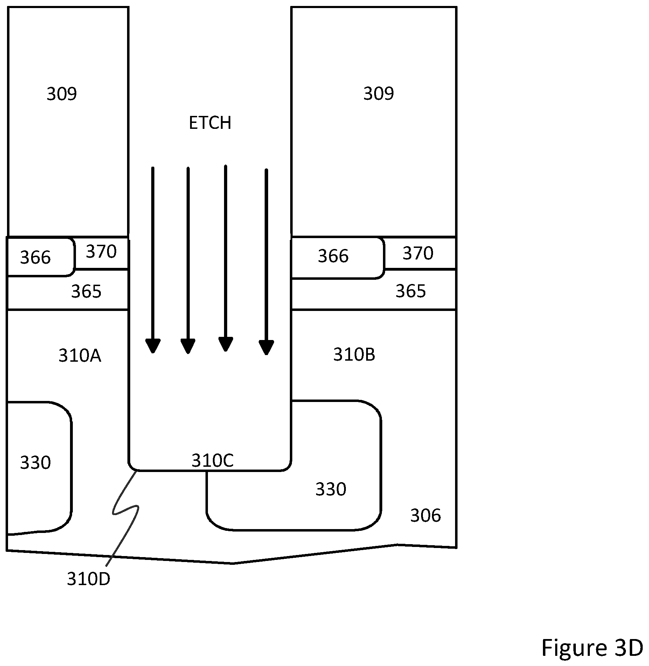

At the next stage shown in Figure 3D a mask 309 is patterned with an opening that may be offset from the p-well region 330. Mask 309 may be of silicon dioxide, or of another suitable material. A trench 310A-C is formed in SiC using plasma etch. Trench 310A-D has the first sidewall 310A, the second sidewall 310B and trench bottom 310C. The trench corner 310D formed by trench bottom 310C and trench sidewall 310A may have a rounding, which rounded corner formation is supported by multiple SiC dry etching tools. In other embodiments the trench rounding may be done by thermal treatment of SiC.

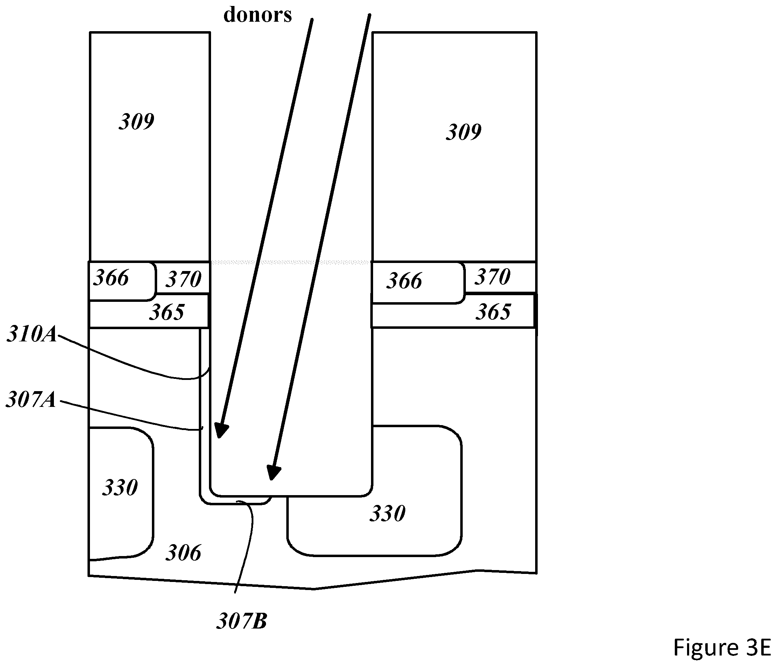

Figure 3E shows formation of the built-in channel 307A, 307B, for which inclined donor ion implant may applied. The built-in channel 307A, 307B may be schematically split into its vertical portion of the built in channel 307A adjacent to trench sidewall 310A and a lateral portion 307B, which 307B is adjacent to trench bottom 310C. The donors used for this stage may be nitrogen, or phosphorus, or arsenic, or antimony, of which nitrogen is the most common in SiC device manufacturing. In some embodiments, the lateral potion 307B may be removed by directional dry etch of SiC after the stage shown in Figure 3D.

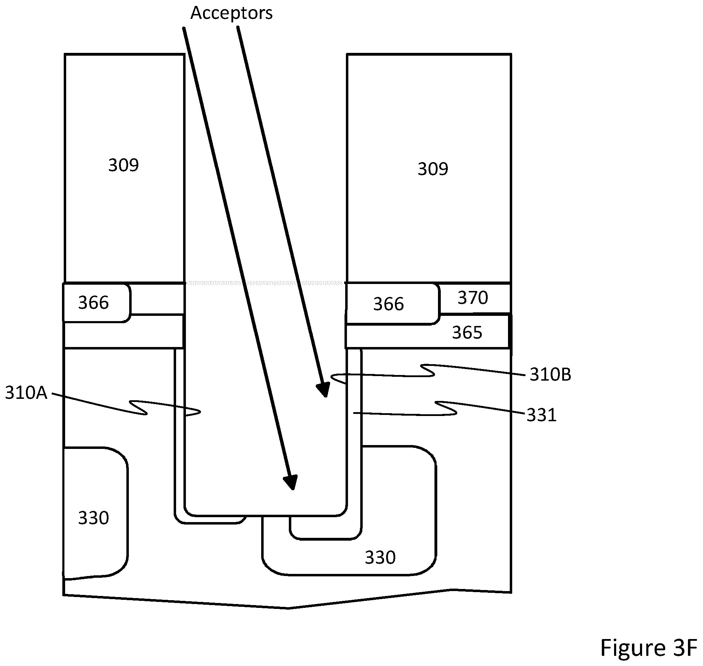

Figure 3F shows formation of p- body 331 using inclined-beam ion implant. The beam tilt angle should be high enough to avoid acceptor implantation into layer 307 as it is shown in Figure 3F, because p-body 331 has higher ion dose than layer 307A, 307B. Preferred ion species are aluminum. A chain-type implant including a high-dose low-energy implantation step may be utilized in order to form a near-surface layer with a doping in excess of 1x10²⁰ acceptors/cm². Such a degenerately-doped layer may facilitate formation of a tunnel-transparent contact between p-body 331and the first layer of p-type polysilicon to be deposited at a later stage. The mask 309 is then removed. Implanted p-well region 330 and p-body 331 form a continuous L-shaped p-body next to the trench in SiC crystal. In further embodiments, the L-shaped p-body may be formed by the tilted ion beam implantation of p-body 331 alone, provided the chain implant includes high Al ion energy stage or stages to obtain the required depth of said p-body.

Ion implantation may be continued after the stage of Figure 3E so as to form required doped layers outside the active cells, such as the junction termination as an example. Fabrication of such regions may be common to other types of SiC power devices, and the fabrication will not be discussed in detail in this disclosure. Ion implantations may be followed by a high-temperature anneal to activate implanted ions, typically at temperatures between 1500° C and 1800° C. Carbon coating of the SiC surface may be used during implant activation stage to avoid SiC surface erosion. Said carbon coating is removed after implant activation.

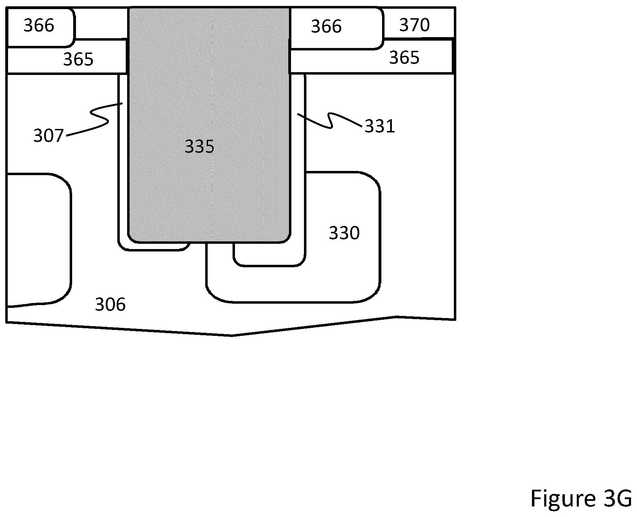

Shown in Figure 3G is the device 3000 post filling the trench with the first polysilicon layer and planarization of the polysilicon. Planarization con be done either by chemical-mechanical polishing (CMP) or by other techniques. The first polysilicon layer may be heavily p-type doped so as to form a high Schottky barrier to SiC in order to avoid excessive off-state leakage of this barrier.

Apart from electrostatic shielding of the gate oxide, the built-in Schottky barrier of the first polysilicon layer to SiC may be used as a non-injection built-in body diode. Interfacial oxide should be removed from the interface of n-type SiC to the first polysilicon. The design of MOSFET 3000 partially addresses this issue by the presence of the rectifier portion formed between regions 307 and 337, which orientation is close to the basal (0001) crystal plane of SiC. Said (0001) crystal plane is more inert chemically than other planes of hexagonal SiC, with the thinnest native oxides.

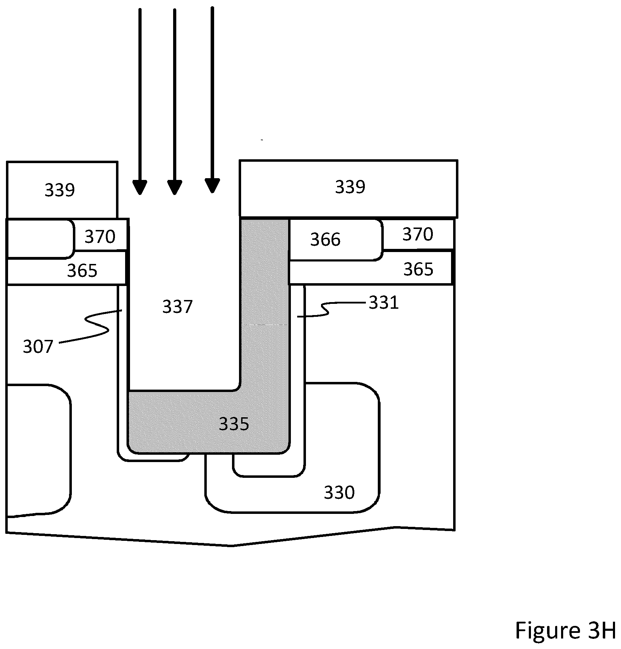

Shown in Figure 3H is the configuration of device 3000 post etch of a trench in polysilicon. Said trench may be dry etched with resist mask. Substantial dry etch of SiC need not occur because of the polysilicon etch being much faster than of SiC. In case the etch selectivity is substandard, and significant removal of layer 307 occurs, an additional tilted implant of nitrogen ions into the open portion sidewall 310A may be applied to maintain required donor dose in BICL 307. No dedicated damage anneal in SiC at above high temperatures above 1500° C is required to activate said nitrogen implant, because low-dose nitrogen implants are already activated at around 1000 C-1200 C, such temperatures may occur anyway at the later stages of manufacturing device 3000. Significant re-crystallization of the first polysilicon 335 may occur at those later stage, with a possibility for compromised electrical insulation of the first ILD between first and second polysilicon layers. A thermal anneal of the polysilicon layer 335 may be performed prior to the thermal oxidation of the first polysilicon 335 to minimize said restructuring at further process stages.

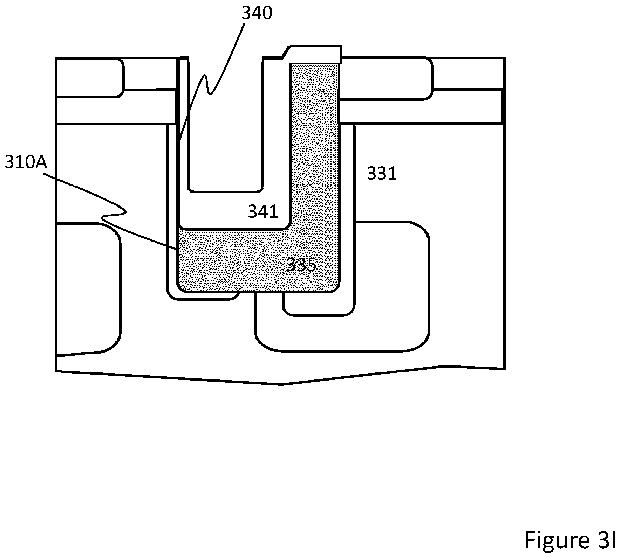

Oxide layer formation is performed at the next stage schematically shown in Figure 3I. A thicker oxide will be formed at the free surface of the first polysilicon layer, and oxide will also be grown at the first SiC sidewall 310A. Thick oxide will form the first ILD, and the first ILD 341 will electrically insulate first and second layers of polysilicon. Thin oxide grown at the free sidewall 310A will form the gate oxide, or, at least, a part of the gate oxide layer. It might be practical that the oxidation recipe is optimized at achieving desired thickness of the first ILD, whereas grown gate oxide at 310A is thinner than the target value which value is between approximately 50 nm and 100 nm. A thin deposited oxide is then applied to increase the gate oxide thickness to desired value.

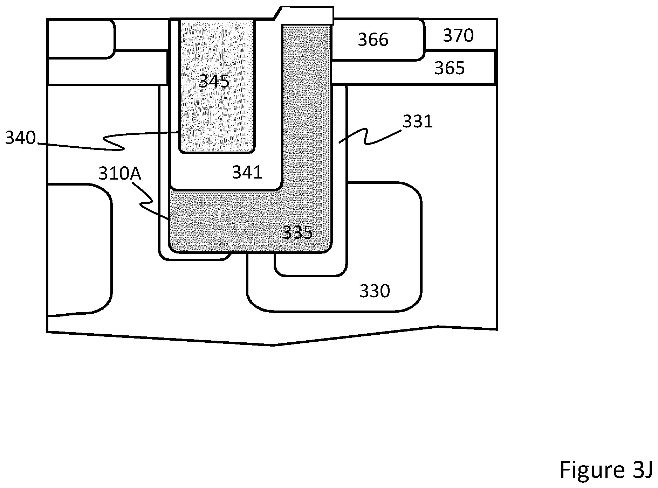

Shown in Figure 3J is the second polysilicon layer 345 is then deposited into the trench in the oxidized trench formed between the gate dielectric 340 of the first ILD 341. The deposition is followed by etchback of the second polysilicon to remove it from topside SiC surface. The etchback may be followed by low-temperature oxidation of the polysilicon to mitigate possible electric field crowding at the top left corner of the gate electrode 345..

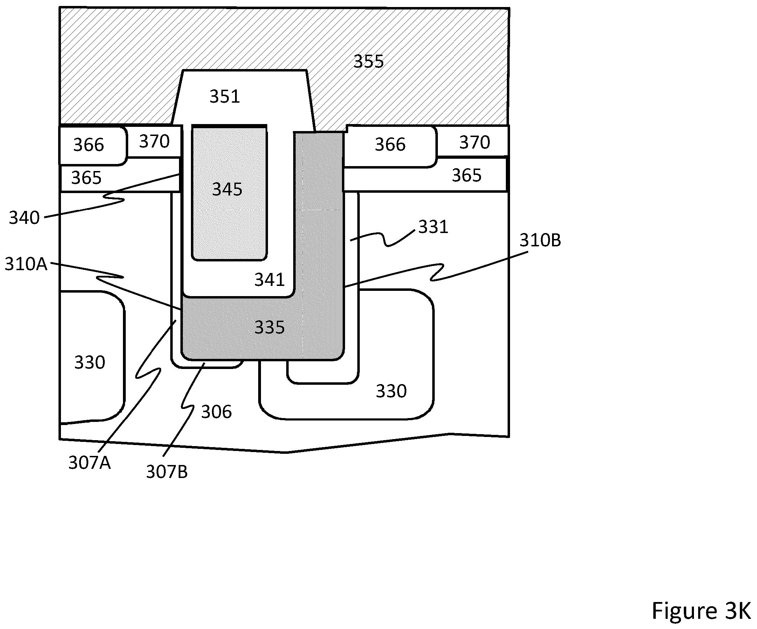

Outside of the active cells a gate pad is formed, in which the second polysilicon layer rests on a layer of field oxide at the topside surface of SiC. Relevant designs and process steps are identical to those used in silicon power MOSFET technology, and they are not shown in Figure 3.

The process is further continued to deposit the second ILD 351 (FIG. 3K) in a manner similar to the first ILD 341 and further removed to open required wells in the topside dielectric, for example to enable contact of the topside contact 355 to the first polysilicon 335 (shown in FIG. 3K). The topside contact 355 is then formed, and the resultant structure is shown in Figure 3K. Figure 3K also illustrates the relative width of the second ILD 351A relative to the width of the first polysilicon 335 at the topside contact 355. The desired width/overlap may be established using the above process. A separate metal contact is also formed at the gate pad. Operation of completed MOSFET 3000 is identical to that of MOSFET 2000 disclosed in relation to Figure 2.

The manufacturing process of device 3000 may further continue to thin down the SiC substrate from its backside to decrease the substrate resistance of MOSFET 3000. Ohmic contacts may be formed after wafer thinning by laser annealing, and a stack of solder metal may be deposited on the backside surface to facilitate die attach. Fully processed wafers may further go through a burn-in, in which burn-in the MOSFET gates are stressed at an elevated temperature between approximately 130° C and 200° C. The burn-in is aimed to locating faulty die with potentially weak gates, which weak gates might have early gate oxide failure in application.

The examples described herein have been described with reference to the accompanying figures. Modifications and alterations will occur to others upon reading and understanding the foregoing examples. Accordingly, the foregoing examples are not to be construed as limiting the present disclosure.

Although the aspects above have been described in considerable detail, numerous variations and modifications will become apparent to those skilled in the art once the above disclosure is fully appreciated. It is intended that the following claims be interpreted to embrace all such variations and modifications.

## Claims

1. A silicon carbide (SiC) metal-oxide-semiconductor field-effect transistor (MOSFET) comprising:
a trench formed at a top side of a SiC crystal that penetrates through a source region, a p-body layer, and a portion of a current spreading layer, wherein the trench has a first sidewall, a second sidewall, and a trench bottom, the trench comprising:
a p-well region arranged on the second sidewall and a portion of the trench bottom to form a continuous L-shaped region;
a first layer of polysilicon arranged as an L-shaped body adjacent to the trench bottom and second sidewall; and
a second layer of polysilicon acting as a gate that is electrically insulated from the first layer of polysilicon by an interlayer dielectric (ILD),
wherein the second layer of polysilicon is arranged between the first layer of polysilicon and the first sidewall, and the second layer of polysilicon is insulated from the first sidewall by a layer of gate oxide, and
wherein the first layer of polysilicon is p-type doped and the first layer of polysilicon and the p-well region are shorted to the source region.

2. The SiC MOSFET of claim 1, wherein the ILD between the first layer of polysilicon and the second layer of polysilicon at least partially comprises a thermal oxide grown on the first layer of polysilicon.

3. The SiC MOSFET of claim 1, wherein an interface of the first layer of polysilicon and the second sidewall is configured to form a Schottky barrier in forward bias.

4. The SiC MOSFET of claim 1, wherein the gate forms an electron inversion channel at an interface of the p-body layer and the gate oxide under positive gate bias.

5. The SiC MOSFET of claim 1, further comprising:
a p-body provided along a portion of the trench bottom and a portion of the second sidewall.

6. The SiC MOSFET of claim 5, wherein a surface of the p-body nearest to a top of the trench comprises Al doping of at least 1x10²⁰ cm⁻³ using hot ion implantation.

7. The SiC MOSFET of claim 1, further comprising:
a built-in channel provided along a portion of the trench bottom and a portion of the first sidewall, wherein the built-in channel forms a passively gated Junction Field Effect Transistor (JFET) with the gate.

8. The SiC MOSFET of claim 1, wherein the SiC crystal is formed from a hexagonal 4H polytype modification of an off-axis silicon-face SiC wafer.

9. A method of manufacturing a SiC metal-oxide-semiconductor field-effect transistor (MOSFET), the method comprising:
ion implanting a current spreading layer on an epitaxial structure, the epitaxial structure comprising a drift region layer disposed on a SiC wafer;
depositing a p-well layer onto the current spreading layer;
depositing a source layer onto the p-well layer;
patterning a first mask to:
ion implant to form a buried p-body region in the current spreading layer;
deposit a sub-contact p-layer after the ion implantation;
removing the first mask;
patterning a second mask to:
etch a trench through the sub-contact p-layer, source layer, and p-well layer into
the current spreading layer and in contact with the buried p-body; and removing the second mask.

10. The method of claim 9, further comprising:
inclined beam ion implanting to form a p-body on a portion of the bottom of the trench and a portion of the sidewall opposite of a built-in channel using the second mask; and
inclined donor ion implanting to form the built-in channel on a portion of the bottom of the trench and a portion of the sidewall of the trench using the second mask.

11. The method of claim 10, wherein the inclined beam ion implanting uses hot ion implantation to obtain a surface of the p-body nearest to a top of the trench with Al doping of over 1x10²⁰ cm⁻³.

12. The method of claim 9, further comprising:
depositing a first polysilicon layer to fill the trench and planarizing the MOSFET after depositing the first polysilicon layer;
etching a portion of the first polysilicon layer to form a second trench;
depositing a layer of dielectric into the etched portion;
depositing a MOS gate over a portion of the layer of dielectric; and
depositing additional dielectric to encompass the gate.

13. The method of claim 12, further comprising:
prior to depositing the additional dielectric to encompass the gate, etching back a portion of the MOS gate, followed by oxidation of a portion of the MOS gate to reduce electric field crowding at a corner of the MOS gate.

14. The method of claim 9, wherein the epitaxial structure derived from a SiC wafer is formed from a hexagonal 4H polytype modification of an off-axis silicon-face SiC wafer.

15. The method of claim 9, wherein the epitaxial structure further comprises:
one or more buffer layers between the drift region layer and SiC wafer.

16. The method of claim 9, further comprising:
rounding a corner at a junction of the trench bottom and the first sidewall.
